# EUROPEAN PATENT APPLICATION

(11) **EP 4 770 281 A1**
(43) Date of publication of application: **01.07.2026**
(21) Application number: 24917320.4
(22) Date of filing: 10.12.2024
(51) Int. Cl.: H05K 1/02, H05K 3/28, H01M 50/519, H01M 50/211, H01M 50/213

(54) **FLEXIBLE CIRCUIT BOARD, AND BATTERY MODULE AND BATTERY PACK INCLUDING SAME**

(30) Priority: 12.01.2024 KR 20240005273
(71) Applicant: LG Energy Solution, Ltd., Seoul 07335 (KR)
(72) Inventor: KIM, Hong Jung, Daejeon 34122 (KR)
(74) Representative: Goddar, Heinz J.
(86) International application number: PCT/KR2024/020163
(87) International publication number: WO 2025/150724

(57) **Abstract**

The present disclosure relates to a battery module, and a battery module according to one aspect of the present disclosure may include a plurality of battery cells; a controller controlling the plurality of battery cells; and a flexible circuit board electrically connecting the plurality of battery cells and the controller, wherein the flexible circuit board may include a substrate body including a plurality of coupling members each coupled to the plurality of battery cells and a plurality of circuit members each connecting the plurality of coupling members and the controller; and a film including a cover member in the shape of a thin film covering an outer surface of the substrate body and a partition member extending from the cover member and interposed between neighboring circuit members of the plurality of circuit members.

## Description

### TECHNICAL FIELD

### CROSS-REFERENCE TO RELATED APPLICATIONS

The present application claims priority to Korean Patent Application No. 10-2024-0005273 filed on January 12, 2024 in the Republic of Korea, the disclosures of which are incorporated herein by reference.

### TECHNICAL FIELD

The present disclosure relates to a flexible circuit board, and a battery module and a battery pack including the same, and more specifically, to a flexible circuit board electrically connecting a battery cell and a battery controller, and a battery module and a battery pack including the same.

### BACKGROUND ART

Secondary batteries have been applied to small-sized applications such as mobile devices or laptop computers, but recently, the research direction has been expanded to medium and large-sized applications, and they are widely used in applications requiring high voltage and large capacity in relation to energy storage systems (ESSs) or electric vehicles (EVs).

When multiple battery cells composed of such secondary batteries are integrated and packaged, a battery module may be formed. Such a battery module may perform a function of charging and discharging electric energy. At this time, the battery module is provided with a battery management system (BMS) that obtains information about the state of the battery cells, such as voltage or current, and controls the operation of the battery module, such as charging and discharging, based on this information.

And, a flexible circuit board (FCB) may be used to electrically connect the battery management system and the battery cells. Circuits connecting the battery management system and the positive electrode and the negative electrode of the battery cell, respectively, may be printed on the flexible circuit board. Through this, the battery management system may individually obtain information about the voltage and current of the battery cell.

At this time, the conventional flexible circuit board may be composed of a metal thin plate on which the above-described circuit is engraved, a film layer covering an outer surface of the metal thin plate, and an adhesive applied therebetween to couple them.

However, the conventional flexible circuit board has a problem that when an overcurrent flows through the circuit or the temperature of the circuit rises excessively, the adhesive between the circuits is burned and thus the film layer swells. This problem may cause additional problems such as short circuit between circuits.

Accordingly, there has been an urgent need to develop a flexible circuit board having high stability, and a battery module and a battery pack including the same, by preventing contact or short circuit between circuits even if an overcurrent flows through the circuit or the temperature of the circuit rises excessively.

### SUMMARY

### TECHNICAL PROBLEM

The present disclosure is designed to solve the problems of the related art, and therefore the present disclosure is directed to providing a flexible circuit board having high stability and a battery module including the same, by being configured to prevent contact or a short circuit between circuits even in an abnormal state such as overcurrent flowing through the circuit or overheating of the circuit.

Technical problems of the present disclosure are not limited to the above-described problems, and other problems not mentioned herein may be clearly understood by those having ordinary skill in the art from the following description of the present disclosure.

### TECHNICAL SOLUTION

According to one aspect of the present disclosure, there is provided a battery module including a plurality of battery cells; a controller controlling the plurality of battery cells; and a flexible circuit board electrically connecting the plurality of battery cells and the controller, wherein the flexible circuit board includes a substrate body including a plurality of coupling members each coupled to the plurality of battery cells and a plurality of circuit members each connecting the plurality of coupling members and the controller; and a film including a cover member in the shape of a thin film covering an outer surface of the substrate body and a partition member extending from the cover member and interposed between neighboring circuit members of the plurality of circuit members.

At this time, the circuit member may include an extension portion having one side connected to the controller and extending in any one direction; and a connection portion connecting the other side of the extension portion to any one of the plurality of coupling members, wherein the partition member may be interposed between the extension portions of neighboring circuit members of the plurality of circuit members.

At this time, the extension portion may extend parallel to the extension portion of the neighboring circuit members.

At this time, the extension portion may include a first extension portion having a first circuit width; and a second extension portion having a second circuit width smaller than the first circuit width, wherein the partition member may be interposed between the second extension portions of neighboring circuit members of the plurality of circuit members.

At this time, the extension portion may include a first extension portion whose spacing with the neighboring circuit member is a first spacing; and a second extension portion whose spacing with the neighboring circuit member is a second spacing that is narrower than the first spacing, wherein the partition member may be interposed between the second extension portions of neighboring circuit members of the plurality of circuit members.

At this time, the circuit member may include a pattern portion having one side electrically connected to the controller and configured to perform a predetermined function; and a connection portion connecting the other side of the pattern portion to any one of the plurality of coupling members, wherein the partition member may be interposed between the pattern portions of neighboring circuit members of the plurality of circuit members.

At this time, the pattern portion may be configured to be disconnected when a voltage or current greater than or equal to a preset magnitude is applied.

At this time, the partition member may be formed by pressing a portion of the film to enter between neighboring circuit members of the plurality of circuit members.

At this time, the partition member may be formed by thermal fusion.

At this time, on an outer surface of the cover member, a groove concavely recessed between neighboring circuit members of the plurality of circuit members may be formed.

At this time, the cover member may be provided on each of both surfaces of the substrate.

At this time, the partition member may each be connected to the cover member where both sides of the substrate body in the thickness direction are provided on each of both surfaces of the substrate.

At this time, the flexible circuit board may further include a coupling layer provided between the substrate body and the cover member for coupling the substrate body and the cover member.

At this time, the coupling layer may be formed of an adhesive.

At this time, the partition member may extend parallel to one section of the circuit member.

At this time, the partition members may be provided in plurality to be respectively provided between each of neighboring circuit members of the plurality of circuit members.

According to another aspect of the present disclosure, there is provided a battery module including a plurality of battery cells; a controller controlling the plurality of battery cells; and a flexible circuit board electrically connecting the plurality of battery cells and the controller, wherein the flexible circuit board includes a substrate body including a plurality of coupling members each coupled to the plurality of battery cells and a plurality of circuit members each connecting the plurality of coupling members and the controller; a film covering an outer surface of the substrate body; a coupling layer provided between the film and the substrate body to couple the film and the substrate body; and a partition member interposed between neighboring circuit members of the plurality of circuit members and made of a different material from the coupling layer.

According to still another aspect of the present disclosure, there is provided a battery pack including a battery module according to any one of the battery modules described above.

According to still another aspect of the present disclosure, there is provided a flexible circuit board for a battery module for electrically connecting a plurality of battery cells provided in a battery module and a controller controlling the same, and the flexible circuit board includes a substrate body including a plurality of coupling members each coupled to the plurality of battery cells and a plurality of circuit members each connecting the plurality of coupling members and the controller; and a film including a cover member covering an outer surface of the substrate body and a partition member extending from the cover member and interposed between neighboring circuit members of the plurality of circuit members.

According to still another aspect of the present disclosure, there is provided a flexible circuit board for a battery module for electrically connecting a plurality of battery cells provided in a battery module and a controller controlling the same, and the flexible circuit board includes a substrate body including a plurality of coupling members each coupled to the plurality of battery cells and a plurality of circuit members each connecting the plurality of coupling members and the controller; a film covering an outer surface of the substrate body; a coupling layer provided between the film and the substrate body to couple the film and the substrate body; and a partition member interposed between neighboring circuit members of the plurality of circuit members and made of a different material from the coupling layer.

### ADVANTAGEOUS EFFECTS

In a flexible circuit board according to one aspect of the present disclosure and a battery module including the same, a partition member is interposed between neighboring circuit members of the flexible circuit board that electrically connects a controller and a battery cell, so that even if an overcurrent flows through the circuit member and deforms the surrounding film or adhesive layer, the partition member may prevent the neighboring circuit members from contacting each other.

Through this, in a flexible circuit board according to one aspect of the present disclosure and a battery module including the same, contact or a short circuit between circuits may be prevented, thereby further improving stability of the flexible circuit board and the battery module.

Effects to be obtained by the present disclosure are not limited to the above-described effects, and other effects not mentioned herein may be clearly understood by those having ordinary skill in the art from this specification and the accompanying drawings.

### BRIEF DESCRIPTION OF THE DRAWINGS

FIG. 1 is a view schematically showing a battery module according to an embodiment of the present disclosure.
FIG. 2 is an enlarged plan view of a portion of a flexible circuit board according to the first embodiment of the present disclosure.
FIG. 3 is a cross-sectional view of the flexible circuit board shown in FIG. 2.
FIG. 4 is an enlarged plan view of a portion of a flexible circuit board according to the second embodiment of the present disclosure.
FIG. 5 is an enlarged plan view of a portion of a flexible circuit board according to the third embodiment of the present disclosure.
FIG. 6 is a cutaway cross-sectional view of a portion of a flexible circuit board according to the fourth embodiment of the present disclosure.

### DETAILED DESCRIPTION

Preferred embodiments of the present disclosure will be described in detail to enable those skilled in the art to easily carry out the present disclosure. However, the present disclosure may be embodied in many different forms and is not limited or restricted by the following embodiments.

To clearly describe the present disclosure, an irrelevant description or a detailed description of related known technology that may unnecessarily obscure the gist of the present disclosure is omitted, and in affixing the reference numerals to the elements in each drawing, the identical or similar reference numerals are affixed to the identical or similar elements throughout the present disclosure.

Additionally, it should be understood that the terms or words used in the present disclosure and the appended claims should not be construed as limited to general and dictionary meanings, but rather interpreted based on the meanings and concepts corresponding to the technical aspect of the present disclosure on the basis of the principle that the inventor is allowed to define terms appropriately for the best explanation.

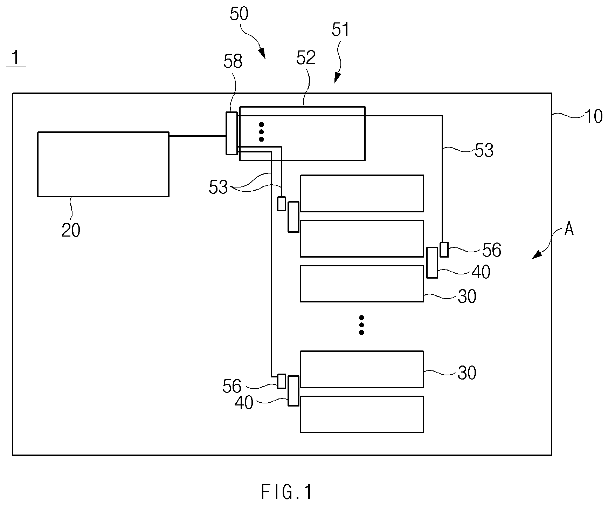

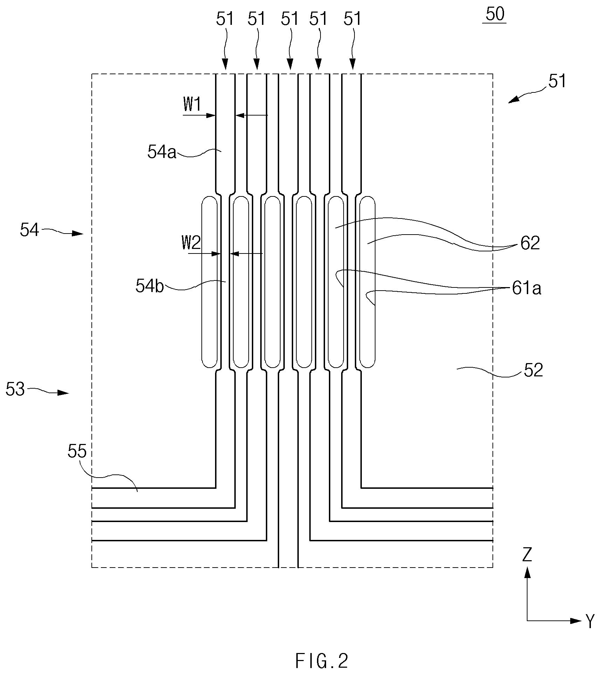

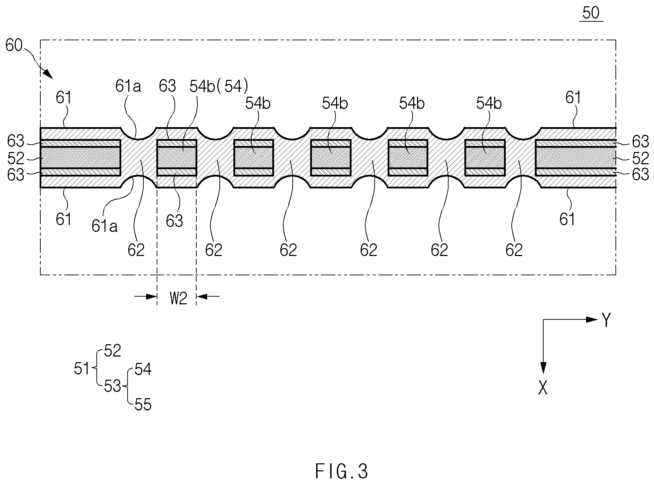

FIG. 1 is a view schematically showing a battery module according to an embodiment of the present disclosure. FIG. 2 is an enlarged plan view of a portion of a flexible circuit board according to the first embodiment of the present disclosure. FIG. 3 is a cross-sectional view of the flexible circuit board shown in FIG. 2.

At this time, each component of the battery module according to an embodiment of the present disclosure is schematically shown in the drawings, and the size of the component, the thickness of the line, and the like may be somewhat exaggerated for convenience of understanding.

In FIGS. 1 to 3, a battery module 1 according to an embodiment of the present disclosure is disclosed. The battery module 1 according to an embodiment of the present disclosure is a device for storing electric energy or releasing electric energy to the outside. In other words, the battery module 1 may charge and discharge electric energy.

This battery module 1 may be used as a configuration of a battery pack. The battery pack may be defined as an assembly in which an aggregate of at least one battery module is packaged. Such a battery pack may be installed in various facilities or locations to provide electric energy. As an example, the battery pack may be installed in a vehicle body of an electric vehicle to provide energy for driving a motor, but is not limited thereto.

Referring to FIG. 1, the battery module 1 according to the first embodiment of the present disclosure may include a housing 10 in the shape of a case. The housing 10 may be formed by coupling several plates to each other.

In this embodiment, the housing 10 may be configured to accommodate other components of the battery module 1. Accordingly, the other components may be protected from external impact or contamination.

Alternatively, the housing 10 may function as a support providing a base where other components may be supported. To this end, the housing 10 may be made of a metal or reinforced plastic having a predetermined rigidity, but is not limited thereto.

Meanwhile, in this embodiment, the housing 10 is provided as a box-shaped assembly in which several frames having plate shapes are coupled to each other, but the shape or structure of the housing 10 is not particularly limited as long as it may accommodate and protect or support other components.

Referring to FIG. 1 again, the battery module 1 according to an embodiment of the present disclosure may include a controller 20. The controller 20 may be installed in and supported by the housing 10. In this embodiment, the controller 20 may be configured to control the operation of a battery assembly A to be described later. As an example, the controller 20 may configure a battery management system (BMS).

In this embodiment, the controller 20 may be configured to individually control battery cells 30 constituting the battery assembly A to be described later. At this time, the controller 20 may be configured to obtain information about the state of each battery cell 30 and to control and manage the battery cells 30 in an integrated manner based on the information. The state of the battery cell 30 may include a voltage, current, capacity, temperature, and the like of the battery cell 30.

To this end, the controller 20 may include an electric circuity, a processor, a central processing unit (CPU), a controller, an arithmetic logic unit, an operational logic circuit, a digital signal processing device, a microcomputer, an FPGA, a system on a chip (SoC), a programmable logic unit, a microprocessor, or any device capable of performing the functions to be described later.

And, a predetermined cable (not shown) may be provided on one side of the controller 20. The cable may be a cable for electrically connecting the battery assembly A and the controller 20. The cable may be composed of multiple wires or a flat flexible cable (FFC), but is not limited thereto.

Referring to FIGS. 1 and 2, the battery module 1 according to an embodiment of the present disclosure may include a battery assembly A. The battery assembly A may be an assembly that is connected to an external power source to store electric energy or is connected to an external load to release electric energy. This battery assembly A may be accommodated inside the housing 10 described above to be protected or supported.

In this embodiment, the battery assembly A may include at least one battery cell 30 to perform a charging and discharging function. The battery cell 30 may include a cell body and a first electrode lead and a second electrode lead provided on an outer side of the cell body.

In this embodiment, the cell body may be provided as a pouch-shaped structure with an electrode assembly provided therein. However, the shape of the cell body may be appropriately modified according to the structure or type of the electrode assembly provided therein. For example, the shape of the cell body may have a cylindrical shape.

In this embodiment, the first electrode lead and the second electrode lead may be leads for electrically connecting the electrode assembly of the cell body to the outside. The first and second electrode leads may be provided in the shape of a film or sheet extending to the outside of the cell body.

Such first and second electrode leads may be provided at the front and rear portions of the cell body, respectively. However, the shape or position of the electrode leads may be appropriately modified according to the structure of the electrode assembly, the shape of the cell body, and the like. For example, the electrode leads may be provided as metal wires or metal pieces having a predetermined length.

At this time, one of the first electrode lead and the second electrode lead may be a lead connected to the positive electrode of the electrode assembly, and the other may be a lead connected to the negative electrode of the electrode assembly.

Meanwhile, referring to FIG. 1, in this embodiment, the battery cell 30 may be configured in plurality. Accordingly, the charging and discharging capacity of this battery module 1 may be increased. Such a plurality of battery cells 30 may be arranged and electrically connected in a predetermined manner.

In this embodiment, the plurality of battery cells 30 may be arranged side by side. And, the plurality of battery cells 30 may be connected in series with each other along the arrangement direction. To this end, the battery assembly A of the battery module 1 according to an embodiment of the present disclosure may include a busbar 40.

In this embodiment, the busbar 40 may be configured to electrically connect the electrode leads of neighboring battery cells 30. The busbar 40 may be provided as a flat metal piece (or a piece of metal), but is not limited thereto.

Meanwhile, referring to FIG. 1 again, the controller 20 of the battery module 1 according to an embodiment of the present disclosure may need to be electrically connected to the battery cells 30, respectively. This may be for the controller 20 to obtain information about the voltage of the battery cell 30 as information on the battery cell 30. For example, the controller 20 may obtain information about the voltage of the battery cell 30 by measuring a potential difference between the first electrode lead and the second electrode lead of the battery cell 30.

To this end, the battery assembly A of the battery module 1 according to an embodiment of the present disclosure may include a flexible circuit board 50. In this embodiment, the flexible circuit board 50 may be configured to electrically connect the first electrode leads 32 of the plurality of battery cells 30 and the controller 20.

Referring to FIGS. 1 to 3, in this embodiment, the flexible circuit board 50 may include a substrate body 51. The substrate body 51 may be a circuit board on which a predetermined circuit is engraved. In this embodiment, the substrate body 51 may be formed of a metal thin sheet. For example, the substrate body 51 may be provided in copper foil, but is not limited thereto.

At this time, the substrate body 51 may have a predetermined degree of flexibility. Accordingly, the flexible circuit board 50 may absorb an external impact or be appropriately bent to conform to the internal structure of the battery module.

And, in this embodiment, a connector 58 may be mounted on the substrate body 51. The connector 58 may be a connector that may be electrically connected to a cable connected to the controller 20. That is, one end of the cable may be connected to the connector 58.

In this embodiment, the substrate body 51 may include a base member 52, a plurality of circuit members 53, and a plurality of coupling members 56. The base member 52 may be a thin plate that supports other configurations of the substrate body 51. This base member 52 may be formed by etching the copper foil forming the substrate body 51.

That is, the base member 52 may be a portion of the copper foil that does not form a circuit in the substrate body 51. The remaining portion of the copper foil forming a circuit in the substrate body 51 may form a circuit member 53 or a coupling member 56 to be described later.

In this embodiment, the plurality of coupling members 56 may be configured to each be coupled to the plurality of busbars 40 electrically connected to the battery cell 30. At this time, the coupling member 56 may be a portion formed by etching the copper foil as described above, or the coupling member 56 may be provided separately and then connected to the circuit member 53 to be described later by welding or the like.

At this time, the coupling member 56 may have a pad shape to be easily coupled to the busbar 40 by a welding process. However, the structure or shape of the coupling member 56 is not particularly limited as long as it may be coupled to the busbar 40 or the electrode lead of the battery cell 30.

Meanwhile, in this embodiment, the coupling member 56 may be connected to the connector 58 by the circuit member 53. That is, the plurality of circuit members 53 may be circuits that electrically connect the plurality of coupling members 56 and the connector 58, respectively. To this end, the number of circuit members 53 may correspond to the number of coupling members 56. As described above, the circuit member 53 may be formed by etching the copper foil forming the substrate body 51.

Referring to FIGS. 1 to 3, in the first embodiment of the present disclosure, the circuit member 53 of the flexible circuit board 50 may include an extension portion 54. The extension portion 54 may be electrically connected to the connector 58. And, the extension portion 54 may extend to be away from the connector 58. At this time, the extension portion 54 may extend side by side with the extension portion 54 of other neighboring circuit members 53.

In this embodiment, the extension portion 54 may include a first extension portion 54a and a second extension portion 54b that are connected to each other. At this time, the first extension portion 54a may have a first circuit width w1, and the second extension portion 54b may have a second circuit width w2 different from the first circuit width w1. At this time, the second circuit width w2 may be smaller than the first circuit width w1.

In this embodiment, the circuit member 53 may include a connection portion 55. The connection portion 55 may be a portion of the circuit member 53 that connects the extension portion 54 and the coupling member 56 to each other.

At this time, in this embodiment, the plurality of coupling members 56 are spaced apart from each other, so that at least a part of the connection portion 55 may extend in a direction away from the connection portion 55 of other neighboring circuit members 53. Through this, the flexible circuit board 50 may transmit a potential applied to the battery cell 30 to the controller through the connector 58 or receive a control signal from the controller.

Meanwhile, in this embodiment, the circuit member 53 provided in the substrate body 51 is described as being connected to another external electric circuit or electric device by the connector 58. However, if necessary, the circuit member 53 may be configured to be directly connected to another external electric circuit or electric device without using a separate connector. To this end, a welding or soldering process for connecting different circuits may be used, but is not limited thereto.

Referring to FIGS. 2 and 3, the flexible circuit board 50 according to the first embodiment of the present disclosure may include a film 60. The film 60 may be a film that protects an outer surface of the substrate body 51. For example, the film 60 may be a polyimide (PI) film having excellent heat resistance and insulation, but is not limited thereto.

In this embodiment, the film 60 may include a cover member 61 in the shape of a thin film. The cover member 61 may be provided on an upper surface and a lower surface of the substrate body 51 to cover the same, respectively. Accordingly, both surfaces of the substrate body 51 may be protected from the outside.

If necessary, the cover member 61 may be provided on only one surface of the substrate body 51. Alternatively, the cover member 61 may be configured to cover only a partial area of one surface of the substrate body 51.

At this time, a coupling layer 63 may be provided between the cover member 61 and the substrate body 51. As an example, the coupling layer 63 may be formed of an adhesive applied to the outer surface of the substrate body 51. Accordingly, the cover member 61 and the substrate body 51 may be coupled to each other.

Meanwhile, as shown in FIG. 2, in the second extension portion 54b of the circuit member 53 having a narrow circuit width, more heat may be generated than in other portions of the circuit member 53. The coupling layer 63 or the cover member 61 around the second extension portion 54b may be deformed by this heat.

As an example, the coupling layer 63 heated by the second extension portion 54b may be burned and vaporized (or expanded). Accordingly, the cover member 61 may be pushed outward. As a result, the second extension portions 54b of the neighboring circuit members 53 may come into contact with each other, which may cause a short circuit.

To prevent this, the film 60 of the battery module according to the first embodiment of the present disclosure may include a partition member 62. In this embodiment, the partition member 62 may extend from the cover member 61 and be interposed between the second extension portions 54b of the neighboring circuit members 53. Accordingly, even if the coupling layer 63 is deformed, the partition member 62 may prevent contact between the circuit members 53 to prevent a short circuit.

At this time, in this embodiment, the partition member 62 may each be connected to the cover member 61 where both sides of the substrate body 51 in the thickness direction (X-axis direction) are provided on each of both surfaces of the substrate body 51. Through this, the partition member 62 may be more stably fixed in position between the second extension portions 54b of the neighboring circuit members 53, thereby properly performing the above-described short-circuit prevention function.

Meanwhile, in this embodiment, the partition member 62 may be formed by pressing a portion of the film 60 to enter between the second extension portions 54b of the neighboring circuit members 53. Alternatively, the partition member 62 may be formed by thermal fusion.

As an example, a high-temperature heater may push a portion of the film 60 covering the substrate body 51 between the second extension portions 54b of the neighboring circuit members 53. For example, the heater may be a soldering iron. Accordingly, the partition member 62 may be formed as the films 60 provided on each of both surfaces of the substrate body 51 are brought into contact with each other and thermally fused.

At this time, in this embodiment, a groove 61a may be formed on an outer surface of the cover member 61. The groove 61a may have a shape recessed between the second extension portions 54b of the neighboring circuit members 53. This groove 61a may extend along the partition member 62.

Meanwhile, in this embodiment, the partition member 62 may be provided in plurality. And, the partition members 62 may be respectively interposed between each of the second extension portions 54b of the neighboring circuit members 53. Therefore, short circuits may be prevented between each of the multiple circuit members 53.

Additionally, in this embodiment, the partition member 62 may be interposed between the second extension portion 54b of the neighboring circuit members 53 and the base member 52. This partition member 62 may be formed in the same manner as described above. Through this, a short circuit between the base member 52 and the circuit member 53 may be prevented.

Meanwhile, referring to FIGS. 2 and 3, the partition member 62 may extend parallel to the second extension portion 54b of the circuit member 53. As shown, the partition member 62 may extend corresponding to the section where the second extension portion 54b having a high probability of generating heat is formed.

As a result, the partition member 62 may prevent a short circuit in the entire area of the second extension portion 54b. However, the partition member 62 may extend beyond the second extension portion 54b as necessary. As an example, the partition member 62 may extend along the entire section where the extension portion 54 of the circuit member 53 is formed, but is not limited thereto.

As described above, according to the battery module 1 according to an embodiment of the present disclosure, the controller 20 may obtain information about the state of the battery cell 30 through the flexible circuit board 50.

Furthermore, according to the battery module 1 according to an embodiment of the present disclosure, a partition member is interposed between neighboring circuit members in the flexible circuit board, so that even if an abnormal state such as overcurrent flowing through the circuit members and generating heat occurs, a short circuit between the circuit members may be prevented.

Meanwhile, in the embodiment shown, all the battery cells are connected to the controller by one flexible circuit board, but, if necessary, the battery cells may be configured to be connected to the controller by multiple flexible circuit boards.

Hereinafter, a flexible circuit board according to another embodiment of the present disclosure will be described with different drawings.

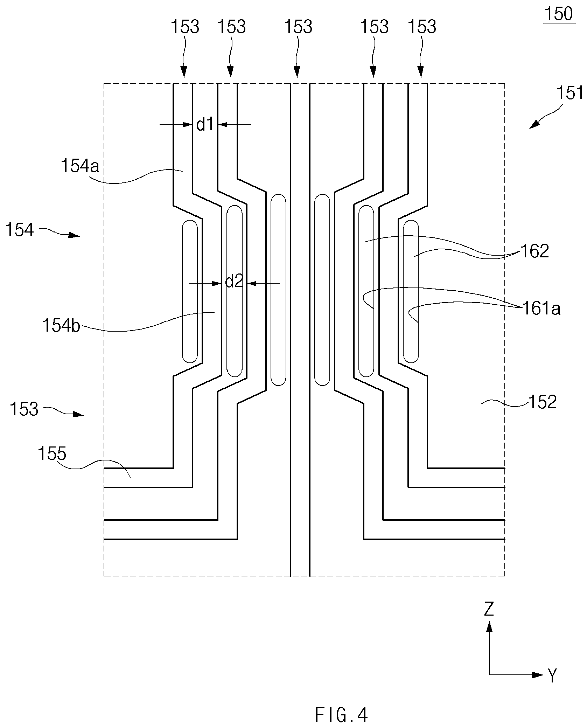

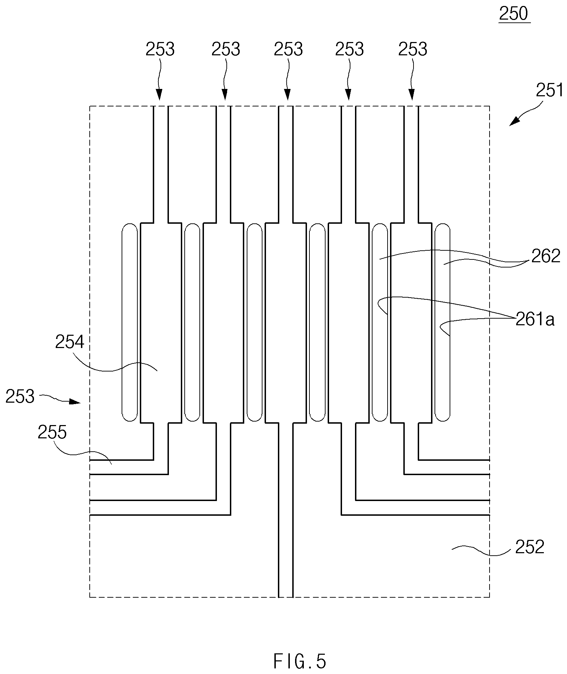

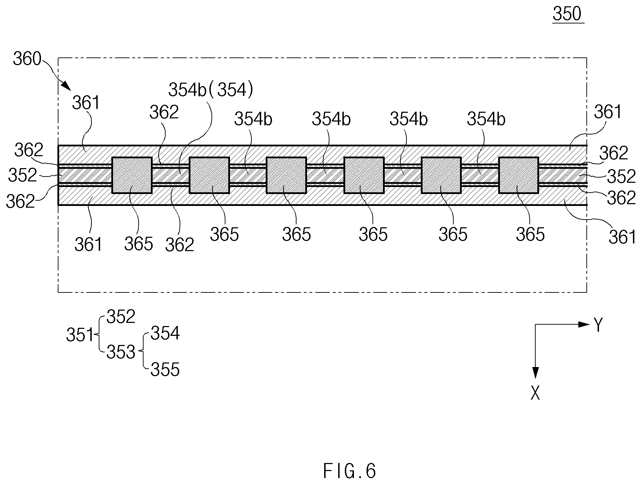

FIG. 4 is an enlarged plan view of a portion of a flexible circuit board according to the second embodiment of the present disclosure. FIG. 5 is an enlarged plan view of a portion of a flexible circuit board according to the third embodiment of the present disclosure. FIG. 6 is a cutaway cross-sectional view of a portion of a flexible circuit board according to the fourth embodiment of the present disclosure.

At this time, each component of the battery module according to another embodiment of the present disclosure is schematically shown in the drawings, and the size of the component, the thickness of the line, and the like may be somewhat exaggerated for convenience of understanding.

First, a flexible circuit board according to the second embodiment of the present disclosure will be described.

FIG. 4 discloses a flexible circuit board 150 according to the second embodiment of the present disclosure. Referring to FIG. 4, the flexible circuit board 150 according to the second embodiment of the present disclosure may include a substrate body 151.

At this time, the substrate body 151 may be formed of a metal thin plate as described in the first embodiment. As an example, the substrate body 151 may be formed of copper foil, but is not limited thereto.

At this time, in this embodiment, the substrate body 151 may include a base member 152, a circuit member 153, and a coupling member. The base member 152 may be a member that supports other configurations of the substrate body 151, and the coupling member may be a member that is electrically connected to the electrode leads of the battery cell. The coupling member may be configured in plurality corresponding to the number of electrode leads of the battery cell.

At this time, the base member 152 may be formed by etching the copper foil forming the substrate body 151 as described in the first embodiment. Here, the base member 152 may be a portion of the substrate body 151 that does not form a circuit.

Meanwhile, in this embodiment, the circuit member 153 may be a circuit that connects a connector mounted on the substrate body 151 to the coupling member. Of course, the circuit member 153 may be connected to other circuit boards or electrical elements by different configurations or coupling structures other than the connector.

At this time, the circuit member 153 may be formed by etching the copper foil forming the substrate body 151, as described in the first embodiment. Here, the circuit member 153 may be a portion forming a circuit in the substrate body 151.

Meanwhile, in this embodiment, the circuit member 153 may include an extension portion 154. One side of the extension portion 154 may be electrically connected to the connector. And, the extension portion 154 may extend in a direction away from the connector. At this time, the extension portion 154 may extend parallel to the extension portion 154 of other neighboring circuit members 153.

In this embodiment, the extension portion 154 may include a first extension portion 154a and a second extension portion 154b that are connected to each other. Here, the first extension portion 154a may be defined as a portion whose spacing with other neighboring circuit member 154 is a first spacing d1. The second extension portion 154b may be defined as a portion whose spacing with other neighboring circuit member 154 is a second spacing d2.

At this time, the second spacing d2 may be narrower than the first spacing d1. In a portion whose spacing with the neighboring circuit member 153 is relatively narrow, such as the second extension portion 154b, more heat may be generated than in other portions.

In this embodiment, the flexible circuit board 150 may include a film protecting the substrate body 151 and a coupling layer provided between the substrate body 151 and the film as described in the first embodiment, and the heat described above may deform the coupling layer or the film.

As an example, as described in the first embodiment, the coupling layer is burned when excessive heat is applied and may push the film outward. This may cause a short circuit between the circuit members 153.

To prevent this, the film may include a partition member 162. At this time, the partition member 162 may be configured in the same manner as the partition member 62 (shown in FIG. 3) according to the first embodiment.

More specifically, the partition member 162 may be formed by pressing a portion of the film between the second extension portions 154b of the neighboring circuit members 153. Accordingly, the partition member 162 may be interposed between the second extension portions 154b of the neighboring circuit members 153.

At this time, the partition member 162 may be formed by thermal fusion so that films provided on both surfaces of the substrate body 151 come into contact between the second extension portions 154b of the neighboring circuit members 153.

As a result, both sides of the partition member 162 in the thickness direction of the substrate body 151 may be connected to other portions of the film provided on both surfaces of the substrate body 151, respectively. At this time, the other portions of the film may be configured in the same manner as the cover member of the first embodiment.

Meanwhile, in this embodiment, the partition member 162 may extend along the second extension portion 154b of the circuit member 153. And, a groove 161a may be provided on an outer surface of the cover member. The groove 161a may have a shape recessed between the second extension portions 154b of the neighboring circuit members 153. The groove 161a may extend along the partition member 162.

Additionally, in this embodiment, the partition member 162 may be provided in plurality. A portion of the plurality of partition members 162 may be interposed between each of the second extension portions 154b of the neighboring circuit members 153. The remaining portions may be interposed between the second extension portion 154b of the circuit member 153 located at the outermost side and the base member 152.

Accordingly, even if there is a section whose spacing with the circuit member 153 is narrowed and where excessive heat is generated, the partition member 162 is configured to prevent excessive deformation of the film or contact between the circuit members 153, so that a short circuit between the circuit members 153 may be effectively prevented.

Meanwhile, in this embodiment, the circuit member 153 may include a connection portion 155. The connection portion 155 may be a circuit that connects the above-described extension portion 154 and the coupling member to each other. At this time, since the plurality of coupling members are spaced apart from each other, at least a part of the connection portion 155 may extend in a direction away from the connection portion 155 of other neighboring circuit members 153.

Next, a flexible circuit board according to the third embodiment of the present disclosure will be described.

FIG. 5 discloses a flexible circuit board 250 according to the third embodiment of the present disclosure. Referring to FIG. 5, the flexible circuit board 250 according to the third embodiment of the present disclosure may include a substrate body 251.

At this time, the substrate body 251 may be formed of a metal thin plate as described in the first embodiment. As an example, the substrate body 251 may be formed of copper foil, but is not limited thereto.

At this time, in this embodiment, the substrate body 251 may include a base member 252, a circuit member 253, and a coupling member. The base member 252 may be a member that supports other configurations of the substrate body 251, and the coupling member may be a member that is electrically connected to the electrode leads of the battery cell. The coupling members may be configured in plurality corresponding to the number of electrode leads of the battery cell.

At this time, the base member 252 may be formed by etching the copper foil forming the substrate body 251 as described in the first embodiment. Here, the base member 252 may be a portion of the substrate body 251 that does not form a circuit.

Meanwhile, in this embodiment, the circuit member 253 may be a circuit for connecting the coupling member and a connector mounted on the substrate body 251. Of course, the circuit member 253 may be connected to other circuit boards or electrical elements by different configurations or coupling structures other than the connector.

At this time, the circuit member 253 may be formed by etching the copper foil forming the substrate body 251, as described in the first embodiment. Here, the circuit member 253 may be a portion forming a circuit in the substrate body 251.

Meanwhile, in this embodiment, the circuit member 253 may include a pattern portion 254 and an extension portion 255. The pattern portion 254 may be a circuit configured to perform a predetermined function. One side of this pattern portion 254 may be electrically connected to the connector.

Meanwhile, although not shown in detail, the pattern portion 254 may be configured with a more complex circuit to perform a predetermined function. For example, the pattern portion 254 may include at least a part that is curved, a part that branches into multiple branches, or a part where multiple branches of circuits are connected to each other.

As an example, the pattern portion 254 may be configured to be disconnected when a current greater than or equal to a preset magnitude is applied to the circuit member 253. In other words, the pattern portion 254 may be configured to function as a fuse. However, the functions that the pattern portion 254 may perform are not limited to the functions described above.

As described above, the pattern portion 254 is configured with a somewhat complex structure to perform a predetermined function, so that relatively more heat may be generated in the pattern portion 254 than in other portions of the circuit member 253.

The flexible circuit board 250 according to this embodiment may include a film protecting the substrate body 251 and a coupling layer provided between the substrate body 251 and the film as described in the first embodiment, and the heat of the pattern portion 254 described above may deform the coupling layer or the film.

As an example, as described in the first embodiment, the coupling layer is burned when excessive heat is applied and may push the film outward. This may cause a short circuit between the circuit members 253.

To prevent this, the film may include a partition member 262. At this time, the partition member 262 may be configured in the same manner as the partition member 62 (shown in FIG. 3) according to the first embodiment.

More specifically, the partition member 262 may be formed by pressing a portion of the film between the pattern portions 254 of the neighboring circuit members 253. Accordingly, the partition member 162 may be interposed between the pattern portions 254 of the neighboring circuit members 153.

At this time, the partition member 262 may be formed by thermal fusion so that films provided on both surfaces of the substrate body 251 come into contact between the pattern portions 254 of the neighboring circuit members 253. As a result, both sides of the partition member 262 in the thickness direction of the substrate body 251 may be connected to other portions of the film provided on both surfaces of the substrate body 251, respectively. At this time, the other portions of the film may be configured in the same manner as the cover member of the first embodiment.

Meanwhile, the partition member 262 may extend along the pattern portion 254 of the circuit member 253. And, in this embodiment, a groove 261a recessed between the pattern portions 254 of the neighboring circuit members 253 may be provided on an outer surface of the cover member. This groove 261a may extend along the partition member 262.

Additionally, in this embodiment, the partition member 262 may be provided in plurality. A portion of the plurality of partition members 262 may be interposed between each of the pattern portions 254 of the neighboring circuit members 253. The remaining portions may be interposed between the pattern portion 254 of the circuit member 253 located at the outermost side and the base member 252.

Accordingly, in this embodiment, even if excessive heat is generated in the pattern portion 254 of the circuit member 253, the partition member 262 may prevent excessive deformation of the film or contact between the circuit members 253, so that a short circuit between the circuit members 253 may be prevented in an abnormal state.

Meanwhile, in this embodiment, the circuit member 253 may include a connection portion 255. The connection portion 255 may be a circuit that connects the above-described pattern portion 254 and the coupling member to each other. At this time, since the plurality of coupling members may be spaced apart from each other, at least a part of the connection portion 255 may extend in a direction away from the connection portion 255 of other neighboring circuit members 253.

Next, a flexible circuit board according to the fourth embodiment of the present disclosure will be described.

FIG. 6 discloses a flexible circuit board 350 according to the third embodiment of the present disclosure. Referring to FIG. 6, in this embodiment, the flexible circuit board 350 may include a substrate body 361 and a film 360.

In this embodiment, the substrate body 361 may include a base member 352, a circuit member 353, and a coupling member. At this time, the base member 352, the circuit member 353, and the coupling member of the substrate body 351 according to this embodiment may be configured identically to the base member 52 (shown in FIG. 2), the circuit member 53 (shown in FIG. 2), and the coupling member 56 (shown in FIG. 2) of the substrate body 51 (shown in FIG. 2) according to the first embodiment, respectively.

Meanwhile, in this embodiment, the film 360 may be configured to protect the substrate body 351. As shown, the film 360 may include a cover member 361 provided on each of both surfaces of the substrate body 351 to cover the same. At this time, the cover member 361 may be configured to cover only a partial area of both surfaces of the substrate body 351.

And, a coupling layer 362 may be provided between the substrate body 351 and the cover member 361. The coupling layer 362 may be a layer for coupling the substrate body 351 and the cover member 361 to each other. For example, the coupling layer 362 may be formed of an adhesive, but is not limited thereto.

In this embodiment, the second extension portion 354b of the circuit member 353 may be a portion whose circuit width is narrower than that of other portions. Alternatively, the second extension portion 354b of the circuit member 353 may be a portion whose spacing with the neighboring circuit member 353 is narrower than that of other portions. Alternatively, the second extension portion 354b may be a portion configured to perform a predetermined function. In this second extension portion 354b, more heat may be generated than in other portions of the circuit member 353.

The heat described above may deform the coupling layer 362 or the film 360. As an example, as described in the first embodiment, the coupling layer 362 is burned when excessive heat is applied and may push the film 360 outward. This may cause a short circuit between the circuit members 353.

To prevent this, the flexible circuit board 350 according to the fourth embodiment of the present disclosure may include a partition member 365 having insulating properties. In this embodiment, the partition member 365 may be interposed between the second extension portions 354b of neighboring circuit members 353. And, the partition member 365 may extend side by side along the second extension portion 354b.

At this time, in this embodiment, the partition member 365 may be made of a different material from the coupling layer 362. For example, the partition member 365 may be made of a material that is more heat resistant than the coupling layer 362. Alternatively, the partition member 365 may be made of a material having a lower thermal strain than the coupling layer 362. Alternatively, the partition member 365 may be made of a material having a lower combustion temperature than the coupling layer 362.

Accordingly, even if excessive heat is generated in the second extension portion 354b of the circuit member 353, the partition member 365 may prevent contact between the circuit members 353, thereby preventing a short circuit between the circuit members 353.

At this time, in this embodiment, the partition member 365 may have a greater thickness than the substrate body 351. Alternatively, the partition member 365 may have a greater thickness than the second extension portion 354b. As a result, even if the second extension portion 354b is somewhat spaced due to deformation of the coupling layer 362 or the film 360, it is possible to more effectively prevent contact or a short circuit between the circuit members 353 by the partition member 362.

Meanwhile, in this embodiment, the partition member 365 may be configured in plurality. And, a portion of the plurality of partition members 365 may be interposed between each of the neighboring second extension portions 354b, and the remaining portions may be interposed between the second extension portion 354b located at the outermost side and the base member 352. Accordingly, a short circuit between the circuit member 353 and the base member 352 may be prevented.

The present disclosure has been hereinabove described with regard to a limited number of embodiments and drawings, but the present disclosure is not limited thereto and may be embodied in different forms by those having ordinary skill in the technical field pertaining to the present disclosure within the technical aspect of the present disclosure and the scope of the appended claims and their equivalents.

### [List of Reference Numerals]

1: Battery module
10: Housing
20: Controller
30: Battery cell
40: Busbar
50, 150, 250, 350: Flexible circuit board

## Claims

1. A battery module comprising:
a plurality of battery cells;
a controller controlling the plurality of battery cells; and
a flexible circuit board electrically connecting the plurality of battery cells and the controller,
wherein the flexible circuit board comprises:
a substrate body comprising a plurality of coupling members each coupled to the plurality of battery cells and a plurality of circuit members each connecting the plurality of coupling members and the controller; and
a film comprising a cover member in the shape of a thin film covering an outer surface of the substrate body and a partition member extending from the cover member and interposed between neighboring circuit members of the plurality of circuit members.

2. The battery module according to claim 1,
wherein the circuit member comprises:
an extension portion having one side connected to the controller and extending in any one direction; and
a connection portion connecting the other side of the extension portion to any one of the plurality of coupling members,
wherein the partition member is interposed between the extension portions of neighboring circuit members of the plurality of circuit members.

3. The battery module according to claim 2,
wherein the extension portion extends parallel to the extension portion of the neighboring circuit members.

4. The battery module according to claim 2,
wherein the extension portion comprises:
a first extension portion having a first circuit width; and
a second extension portion having a second circuit width smaller than the first circuit width,
wherein the partition member is interposed between the second extension portions of neighboring circuit members of the plurality of circuit members.

5. The battery module according to claim 2,
wherein the extension portion comprises:
a first extension portion whose spacing with the neighboring circuit member is a first spacing; and
a second extension portion whose spacing with the neighboring circuit member is a second spacing that is narrower than the first spacing,
wherein the partition member is interposed between the second extension portions of neighboring circuit members of the plurality of circuit members.

6. The battery module according to claim 1,
wherein the circuit member comprises:
a pattern portion having one side electrically connected to the controller and configured to perform a predetermined function; and
a connection portion connecting the other side of the pattern portion to any one of the plurality of coupling members,
wherein the partition member is interposed between the pattern portions of neighboring circuit members of the plurality of circuit members.

7. The battery module according to claim 6,
wherein the pattern portion is configured to be disconnected when a current greater than or equal to a preset magnitude is applied.

8. The battery module according to claim 1,
wherein the partition member is formed by pressing a portion of the film to enter between neighboring circuit members of the plurality of circuit members.

9. The battery module according to claim 8,
wherein the partition member is formed by thermal fusion.

10. The battery module according to claim 1,
wherein on an outer surface of the cover member, a groove concavely recessed between neighboring circuit members of the plurality of circuit members is formed.

11. The battery module according to claim 1,
wherein the cover member is provided on each of both surfaces of the substrate.

12. The battery module according to claim 11,
wherein the partition member is each connected to the cover member where both sides of the substrate body in the thickness direction are provided on each of both surfaces of the substrate.

13. The battery module according to claim 1,
wherein the flexible circuit board further comprises a coupling layer provided between the substrate body and the cover member for coupling the substrate body and the cover member.

14. The battery module according to claim 13,
wherein the coupling layer is formed of an adhesive.

15. The battery module according to claim 1,
wherein the partition member extends parallel to one section of the circuit member.

16. The battery module according to claim 1,
wherein the partition members are provided in plurality to be respectively provided between each of neighboring circuit members of the plurality of circuit members.

17. A battery module comprising:
a plurality of battery cells;
a controller controlling the plurality of battery cells; and
a flexible circuit board electrically connecting the plurality of battery cells and the controller,
wherein the flexible circuit board comprises:
a substrate body comprising a plurality of coupling members each coupled to the plurality of battery cells and a plurality of circuit members each connecting the plurality of coupling members and the controller;
a film covering an outer surface of the substrate body;
a coupling layer provided between the film and the substrate body to couple the film and the substrate body; and
a partition member interposed between neighboring circuit members of the plurality of circuit members and made of a different material from the coupling layer.

18. A battery pack comprising a battery module according to claim 1 or claim 17.

19. A flexible circuit board for a battery module for electrically connecting a plurality of battery cells provided in a battery module and a controller controlling the same, the flexible circuit board comprising:
a substrate body comprising a plurality of coupling members each coupled to the plurality of battery cells and a plurality of circuit members each connecting the plurality of coupling members and the controller; and
a film comprising a cover member covering an outer surface of the substrate body and a partition member extending from the cover member and interposed between neighboring circuit members of the plurality of circuit members.

20. A flexible circuit board for a battery module for electrically connecting a plurality of battery cells provided in a battery module and a controller controlling the same, the flexible circuit board comprising:
a substrate body comprising a plurality of coupling members each coupled to the plurality of battery cells and a plurality of circuit members each connecting the plurality of coupling members and the controller;
a film covering an outer surface of the substrate body;
a coupling layer provided between the film and the substrate body to couple the film and the substrate body; and
a partition member interposed between neighboring circuit members of the plurality of circuit members and made of a different material from the coupling layer.
